# EUROPEAN PATENT APPLICATION

(11) **EP 4 011 593 A1**
(43) Date of publication of application: **15.06.2022**
(21) Application number: 21158443.8
(22) Date of filing: 22.02.2021
(51) Int. Cl.: B29C 45/16, B29C 45/14, H05K 3/00, H05K 3/10, H05K 3/42

(54) **IN-MOLD ELECTRONIC STRUCTURE USING PLATING PROCESS AND METHOD THEREFOR**

(30) Priority: 14.12.2020 KR 20200174369
(71) Applicant: Intops. Co., Ltd., Anyang-si, Gyeonggi-do 14088 (KR)
(72) Inventor: HONG, Tae Yong, 14088 Anyang-si, Gyeonggi-do (KR); AHN, Jun Young, 14088 Anyang-si, Gyeonggi-do (KR)
(74) Representative: M. Zardi & Co S.A.

(57) **Abstract**

An in-mold electronic structure according to the present invention comprises a film with a design; a first plastic resin disposed under the film, and a second plastic resin disposed under the first plastic resin, wherein an electronic circuit is formed on a top side or both sides of the second plastic resin, wherein an electronic device is mounted on the top side or the both sides of the second plastic resin, wherein the film, the first plastic resin, and the second resin with the electronic circuit and the electronic device, are integrated.

## Description

### FIELD OF THE INVENTION

The present invention relates to an in-mold electronic structure using a plating process and method therefor.

### BACKGROUND OF THE INVENTION

In-mold electronics (IME) technology is based on a combination of printed conductive ink and in-mold decoration, which has recently emerged. After Ford first deployed an overhead console based on this technology on a commercial scale in the automobile fields, it has developed rapidly and now it has been expanded to appliances, medical equipment, portable electronics, defense field, and aviation field.

The IME technology generally comprises a first step of printing a decoration, a touch control, or an antenna on a plastic film, a second step of mounting various electronic devices on the film, a third step of manufacturing a three dimensional shape by thermoforming the film, and the last step of integrating the three dimensional film and a plastic resin by insert forming. The finished product manufactured according to the process above, can be mounted on the dash board of driver's seat or the door trim, to be seen as a sleek exterior film. It also can be used to open the door or the window by touching the film, which is similar to the operation of the screen touch or the push motion of smart phones. IME products have a variety of advantages such as providing most of electrical and electronic functions which are required to automobiles; not requiring many components such as a mechanical button, a knob, a link, a shaft, or a motor; enabling space saving; and providing an excellent exterior design.

According to prior arts related to the IME, a manufacturing process using two films is as following:
First, after printing a design on a top film, form the film with the design to be a certain shape, and cut the film A. The design may be decoration, logo, emblem, button designs for operating or functioning an item, but is not limited to.

Meanwhile, after an electronic circuit is printed on a bottom film with a conductive ink, an electronic device is mounted on and combined to the bottom film through a reflow process. Then, form the bottom film to have the same shape as the top film, and cut the bottom film.

Lastly, the top film, the plastic resin, and the bottom film is processed by inset injection molding, and the final product is completed.

However, the method above restricts a design of a conductive circuits depending on a shape of the bottom film, and it is also significantly complicated.

According to prior arts related to the IME, Korean Patent Publication No. 10-2016-0094936 discloses a process of manufacturing a film, forming a conductive structure and a graphic on the film, attaching an electronic device on the film, and injection molding them into a three dimensional shape. Korean Patent Publication No. 10-2017-0130395 discloses a process of screen printing an electrical conductor on a substrate, mounting an electronic device, and injection molding them into a three dimensional shape. United States Patent Publication No. 2018-0213651 discloses a process of forming a conductive circuit on a film, mounting an electronic device, heat molding the film into a three dimensional structure. These patent documents have limitations as to they only disclose a general process of mounting an electronic circuit pattern and an electronic device on a single film and forming the film.

In consideration of the prior arts above, inventors have developed a new IME structure comprising multiple layers and the method therefor.

The present invention provides a strong and durable IME structure, which can be applied to automobiles or appliances, and a quick, simple, and efficient manufacturing method therefor.

### SUMMARY OF THE INVENTION

The present invention provides an in-mold electronic structure comprising: a film with a design; a first plastic resin disposed under the film, and a second plastic resin disposed under the first plastic resin, wherein an electronic circuit is formed on a top side or both sides of the second plastic resin, wherein an electronic device is mounted on the top side or the both sides of the second plastic resin, wherein the film, the first plastic resin, and the second resin with the electronic circuit and the electronic device, are integrated.

An overall shape of the first plastic resin is similar to that of the film, wherein a top side of the first plastic resin is combined with a bottom side of the film, wherein the first plastic resin encapsules entireties of the top side and a lateral side of the second plastic resin.

A height of the second plastic resin is shorter than that of the first plastic resin, wherein a width of the second plastic resin is shorter than that of the first plastic resin, wherein a bottom side of the second plastic resin is exposed to outside.

A bottom side of the first plastic resin comprises: an exposed part extended from an outermost edge of the in-mold electronic structure to the lateral side of the second plastic resin, and an unexposed part directly facing the lateral side and the top side of the second plastic resin and combining with the second plastic resin.

The electronic circuit formed on the top side of the second plastic resin is electrically connected to an external terminal under the bottom side of the second plastic resin through one of structures: a terminal that is connected the electronic circuit at the top side of the second plastic resin, extended from the top side to the bottom side of the second plastic through a penetrating hole formed in the second plastic resin, and exposed downward, or a portion of the electronic circuit extended from the top side to the bottom side of the second plastic through the penetrating hole and exposed downward.

In addition, the present invention provides a method of an in-mold electronic structure comprising a film with a design, a first plastic resin disposed under the film, and a second plastic resin disposed under the first plastic resin, manufacturing the film comprises: manufacturing a material layer with elastic plastic resin; forming a design on the material layer using one of methods: printing using one of silk screen, pad printing, ink jet printing, offset printing, or digital printing; deposition, or UV molding, manufacturing a three dimensional shape by performing a forming process on the material layer with the design, the forming process one of heat forming, vacuum forming, or high pressure forming, and cutting the material layer in the three dimensional shape to fit on a size of a product and completing the film.

Furthermore, the present invention provides a method of an in-mold electronic structure comprising a film with a design, a first plastic resin disposed under the film, and a second plastic resin disposed under the first plastic resin, manufacturing the second plastic resin comprises: injection molding the second plastic resin according to a shape of a product, the injection molding comprising forming a penetrating hole in the second plastic resin; forming an electronic circuit, by a plating process, on a top side, or both sides including the top side and a bottom side of the second plastic resin that is injection molded; forming a protection layer on the electronic circuit formed on the bottom side of the second plastic resin when the electronic circuit is formed on the top and the bottom side of the second plastic resin, and mounting an electronic device on the top side, or the top and bottom side of the second plastic resin with the electronic circuit by soldering, in order to minimize heat damage to the top side, or the top and the bottom side of the second plastic resin with the electronic circuit, the soldering comprising: low temperature soldering using a low thermosetting soldering paste, or local area heating soldering that is heating only a local area where a soldering paste is applied.

The forming the electronic circuit on the second plastic resin by the plating process comprises: performing a pre-treatment of the top side of the second plastic resin with alkaline solution or acidic solution for the plating process; forming a fine concave and convex part on an area of the second plastic resin that the electronic circuit will be formed on, using laser, and performing the plating process that conductive metal is filled in the concave part in order to embody the electronic circuit.

The present invention provides a method of an in-mold electronic structure comprising a film with a design, a first plastic resin disposed under the film, and a second plastic resin disposed under the first plastic resin, the method comprises: providing the film and the second plastic resin, each formed according to a shape of a product, and mounting the film on a top portion of a cavity of a mold and the second plastic resin on a bottom portion of the cavity, a shape of the cavity same as that of the product, and forming the first plastic resin and completing the in-mold electronic structure comprising the film, the first plastic resin, and the second plastic resin by injecting a material of the first plastic resin into the cavity, filling the cavity with the material, and molding the structure under a designated temperature and pressure.

The providing the second plastic resin comprises: injection molding the second plastic resin according to a shape of a product, the injection molding comprising forming a penetrating hole in the second plastic resin; forming an electronic circuit on a top side, or the top and a bottom side of the second plastic resin that is injection molded by a plating process; forming a protection layer on the electronic circuit formed on the bottom side of the second plastic resin when the electronic circuit is formed on the top and the bottom side of the second plastic resin, and mounting an electronic device on the top side, or the top and bottom side of the second plastic resin with the electronic circuit by one of low temperature soldering or local area heating soldering.

### BRIEF DESCRIPTION OF THE DRAWINGS

FIG. 1 is a sectional view showing components of an IME structure of the present invention.
FIG. 2 is a flow chart showing a manufacturing process of a film of the present invention.
FIG. 3 is a drawing showing shapes of the film of the present invention in each step according to the manufacturing process of FIG. 2.
FIG. 4 is a flow chart showing a manufacturing process of a second plastic resin of the present invention.
FIG. 5 is a drawing showing shapes of the second plastic of the present invention in each step according to the manufacturing process of FIG. 4.
FIG. 6 is a drawing showing one embodiment of a process that forms of an electric circuit by applying plating process of the present invention.
FIG. 7A is a drawing showing a terminal portion structure in order to connect between the electric circuit of the present invention and a main board.
FIG. 7B is another drawing showing a terminal portion structure in order to connect between the electric circuit of the present invention and the main board.

### DETAILED DESCIPTION EMBODIEMENTS OF THE INVENTIONS

Each embodiment according to the present invention is to help understanding of the present invention, and the present invention is not limited to these embodiments. The present invention may consist of a combination of at least one of respective component and respective function that is included in the embodiments.

### <IME structure 1>

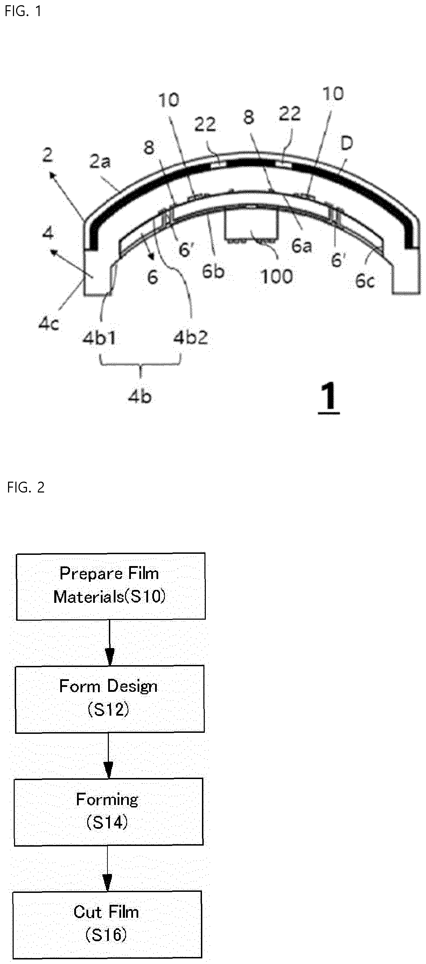

FIG. 1 is a sectional view showing components of an IME structure of the present invention. The IME structure can be applied to automobiles, appliances, or mobile phones, and others. The explanation below primarily exemplifies applications to the automobile, but the present invention is not limited to.

The IME structure 1 comprises, from the top, a film 2, a first plastic resin 4 disposed under the film 2, a second plastic resin 6 disposed under the first plastic resin 4, an electric circuit 8 and an electric device 10 formed on a top side 6a, or both sides including the top side 6a and a bottom side 6b of the second plastic resin 6. The IME structure 1 is an integrated structure of the film 2 with a design D, the first plastic resin 4, and the second plastic resin 6 that the electric circuit 8 and the electric device 10 are formed on.

On the film 2, the design D, such as decoration, logo, emblem, button designs for operating or functioning an item, and others, may be formed. Materials of the film 2 may be various such as PC, PMMA, PET, TPU, and others, but is not limited to. The film 2 in FIG. 1 is illustrated as a disk shape that have a convex shape in a center and a flat shape in a lateral side but is not limited to. The film 2 comprises a penetrating hole 22 in a printed layer or a design consisting layer in order to enable light to pass through. The top side 2a of the film 2 is exposed to outside and seen from outside. Light from the electric device 10 such as LED may be emitted through the penetrating hole 22.

The overall shape of the first plastic resin 4 is similar to that of the film 2. The top side 4a of the first plastic resin 4 is combined with the bottom side 2b of the film 2. The height of first plastic resin 4 is high enough to surround the lateral side 6c of the second plastic resin 6; the first plastic resin 4 has a solid and thick structure encapsulating the entire top side 6a and the lateral side 6c of the second plastic resin 6. Materials of the first plastic resin 4 may be PC, Acrylic, ABS, AES, and others, but is not limited to.

The second plastic resin 6 is a disk shape similar to the film 2; however, the height of the second plastic resin 6 is shorter than that of the first plastic resin 4, and the width of the second plastic resin 6 is shorter than that of the first plastic resin 4. Accordingly, as described above, the top side 6a and the lateral side 6c of the second plastic resin 4 are thoroughly covered by the first plastic resin 4. However, the entire bottom side 6b of the second plastic resin 6 is exposed to outside and has the same shape as the top side 6a of the second plastic resin 6. Thus, the bottom side 4b of the first plastic resin 4 comprises an exposed part 4b1 extended from an outermost edge of the IME structure 1 to the lateral side 6c of the second plastic resin 6, and an unexposed part 4b2 directly facing the lateral side 6c and the top side 6a of the second plastic resin 6 and combining with the second plastic resin 6. Materials of the second plastic resin 6 may be PC, Acrylic, ABS, AES, and others, but is not limited to.

The electric circuit 8 may comprise a circuit pattern, a cable, or conductive ink to supply current or power to the electric device 10 but is not limited to. The electric circuit 8 is formed on the top side 6a, or both sides including the top side 6a and the bottom side 6b of the second plastic resin 6 using a plating process as explained later. The electric circuit 8 can be chosen according to the required specifications.

The electric device 10 comprises a LED device, a capacitance sensor, a chip, a processor, an electric switch, and others, any of which can be selected according to the purpose of the IME structure 1 and mounted on the top side 6a, or both sides including the top side 6a and the bottom side 6b of the second plastic resin 6.

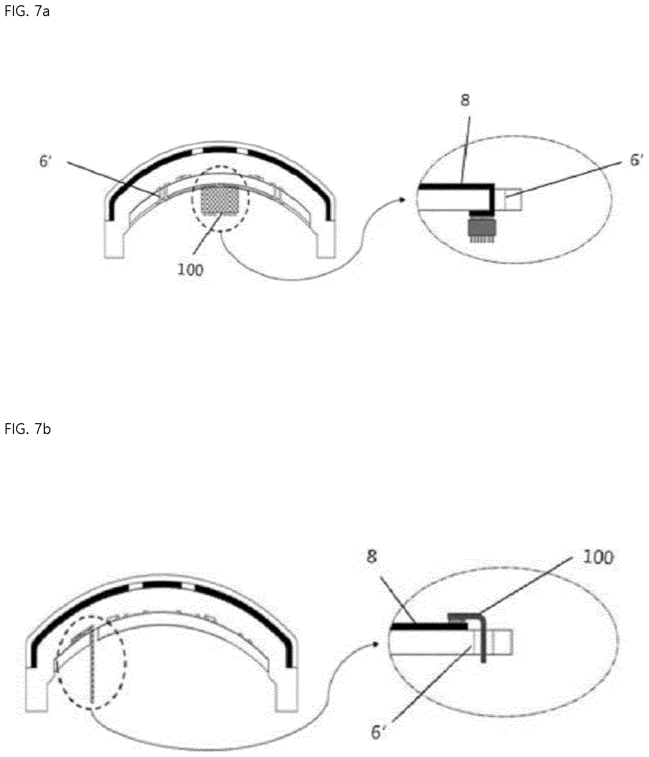

In addition, in order to an electrical connection between the electric circuit 8 and a main board (not shown) which will be disposed under the bottom side of the second plastic resin 6, the IME structure 1 may comprise one of connection structures: a terminal 100, such as a Flexible Printed Circuit Board (FPCB) or a metal pin, connected to the electronic circuit 8 can be extended from the top side 6a to the bottom side 6b of the second plastic resin 6 through a penetrating hole 6', and exposed downward. Instead, a portion of the electronic circuit 8 can be extended from the top side 6a to the bottom side 6b of the second plastic resin 6 through the penetrating hole 6' and exposed downward. The electrical connection between the electric circuit 8 and a main board (not shown) will be described in more detail referring to FIGs. 7a and 7b.

The electric circuit 8 and the electric device 10 formed on the top side 6a of the second plastic resin 6 are encapsulated by the first plastic resin 4, and the electric circuit 8 and the electric device 10 formed on the bottom side 6b are sealed by an extra coating layer. Thus, the electric circuit 8 and the electric device 10 can be durable enough to endure external shocks, deformations, or damage.

Furthermore, the extra coating layer may not be needed in a structure where the electric circuit 8 and the electric device 10 are not formed on the bottom side 6b of the second plastic resin 6.

The structural meaning and the property characteristics of the IME structure 1 of the present invention described above will be more clarified by a manufacturing process of each component as described below.

### <The manufacturing process of the film 2>

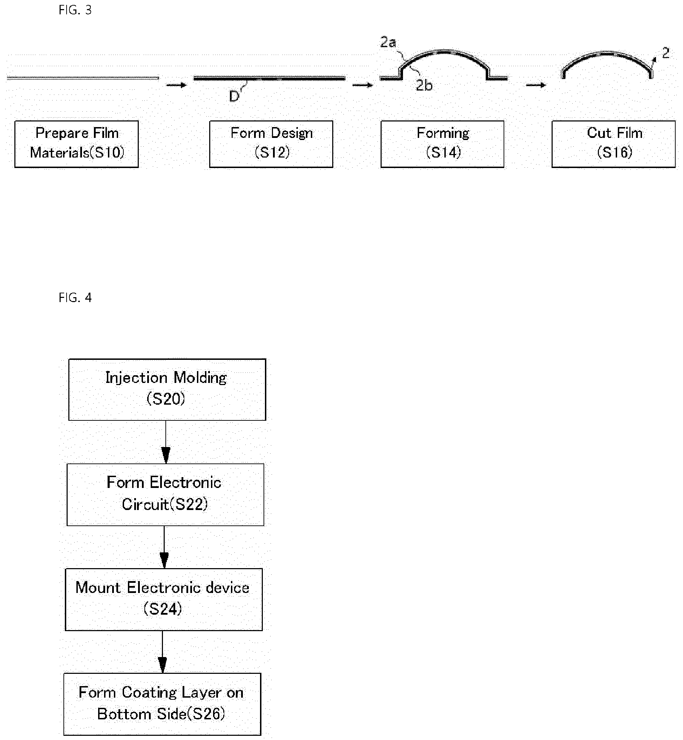

FIG. 2 is a flow chart showing the manufacturing process of the film of the present invention. FIG. 3 is a drawing showing shapes of the film 2 of the present invention in each step according to the manufacturing process of FIG. 2.

Referring to FIGs. 2 and 3 together, first, materials of the film 2 of the present invention is prepared in a planar shape S10. Materials of the film 2 may be various kinds of elastic materials. For example, the materials of the film 2 may be PC, PMMA, PET, TPU, and others but is not limited to.

Then, a design D is formed on the material layer S12. A printing process of the design D may be performed using silk screen, pad printing, ink jet printing, offset printing, or digital printing. The design D may be formed using deposition or UV molding as well as printing.

After finishing steps above, a film in an intermediate state is formed into a three dimensional shape using a forming process as illustrated in drawings S14. The forming process is processed using heat forming, vacuum forming, or high pressure forming. The film is manufactured as the three dimensional shape according to the shape of the product by the forming process.

Then, the film formed according to the shape of the product is cut to fit the size of the product S16. The cutting process may be performed using press punching, CNC process, or laser process.

### <The process of the second plastic resin with the electric circuit 8 and the electric device 10>

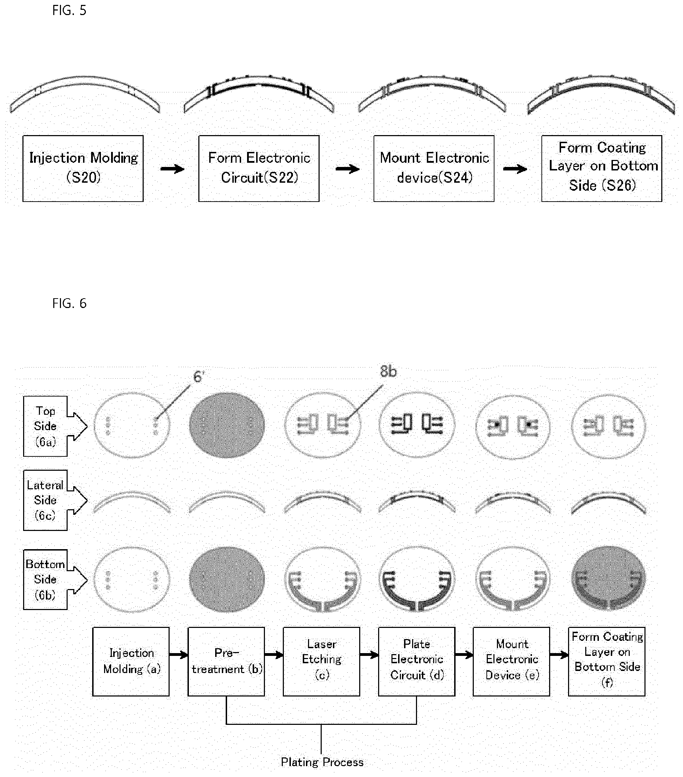

FIG. 4 is a flow chart showing a manufacturing process of a second plastic resin of the present invention. FIG. 5 is a drawing showing shapes of the second plastic of the present invention in each step according to the manufacturing process of FIG. 4.

First, the second plastic resin 6 is formed according to the shape of the product using injection molding S20. While injection molding, the penetrating hole 6' for the terminal part 100 is also formed together.

Then, the electronic circuit 8 is formed, by a plating process, on the top side 6a, or both sides including the top side 6a and the bottom side 6b of the second plastic resin 6, S22.

An engineering plastic plating process comprises a pre-treatment, an etching process, and a plating process of the electronic circuit 8. The plating process can embody various shapes of patterns regardless of types of materials and does not produce a protruded or layered structure in the result, which is an advantage compared to other types of processes.

FIG. 6 is a drawing showing one embodiment of a process that forms an electronic circuit using the plating process of the present invention. A surface to be plated, the top side 6a, or both sides including the top side 6a and the bottom side 6b of the second plastic resin 6, is pre-treated with alkaline solution or acidic solution for the plating process. The surface to be plated also passes through a grease removing process, a cleaning process, and a catalyst activation process considering its surface condition and its adhesion degree to metal materials which will be used as the electronic circuit. In the etching process, fine etched parts 8b are formed using a laser on an area of the second plastic resin 6 where the electronic circuit 8 will be formed. Conductive metal is filled in the etched parts 8b to embody the electronic circuit 8 in the plating process. In the plating process after the etching and pre-treatment process, it is desirable to use an electroless plating than an electroplating.

Then, the electronic device 10 is mounted on the top side 6a, or both sides including the top side 6a and the bottom side 6b of the second plastic resin 6 with the electronic circuit 8, S24. The electronic device 10 may be a device which has an electronical function such as LED, IC chip, and others. In order to minimize heat damage to the second plastic resin 6, low temperature soldering is applied in the mounting process. Specifically, the low temperature soldering can be performed using two methods: a method of applying a low thermosetting soldering paste and pasting together, and another method of applying a general soldering paste in certain local area and pasting together by heating only the local area where the soldering paste is applied. Each method is selectively used according to required specifications in order to minimize the heat damage to the second plastic resin 6. When mounting the electronic device 10, pins of the electronic device 10 is molten and fixed to the surface of the second plastic resin 6 through a reflow process. It is desirable that the reflow process should be performed under a temperature that minimizes the heat damage to the second plastic resin 6.

Then, in case the electronic circuit 8 and the electronic device 10 are formed on the bottom side of the second plastic resin 6, a coating layer is formed on the electronic circuit 8 and the electronic device 10 which are formed on the bottom side of the second plastic resin 6 in order that the IME structure is durable enough to endure external shocks, deformations, or damage.

Hereafter, an electrical connection structure of the present invention will be explained referring to FIGs. 7a and 7b. The electrical connection structure is a connection between the electronic circuit 8 formed on the top side 6a of the second plastic resin 6 and a main board (not shown), which will be disposed under the second plastic resin 6.

First, FIG. 7A discloses an electrical connection structure that a portion of the electronic circuit 8 extended from the top side 6a to the bottom side 6b of the second plastic resin 6 through the penetrating hole 6' and exposed downward. The exposed portion of the electronic circuit 8 can be connected to a main board at the bottom side 6b of the second plastic resin 6 through one of a connector terminal, a pad, or a Flexible Printed Circuit Board (FPCB) shown in a magnified view. In this case, the components above correspond to the terminal 100 in FIG. 1.

On the other hand, FIG. 7B discloses another connection structure. A terminal 100 connected to the electronic circuit 8 at the top side 6a of the second plastic resin 6, can be extended from the top side 6a to the bottom side 6b of the second plastic resin 6 through a penetrating hole 6' formed in the second plastic resin 6, and exposed downward. The terminal 100 is one of a Flexible Printed Circuit Board (FPCB), a pad, or a conductive metal pin.

The terminal part 100 is exposed downward in order to be electrically connected to the main board (not shown). FIGs. 7a and 7b illustrate that the terminal part 100 is grounded. The penetrating hole 6' is formed in a proper area such as a center or lateral side of the second plastic resin 6.

The electronic circuit 8 and the electronic device 10 are fixed on the top side 6a, or both sides including the top side 6a and the bottom side 6b of the second plastic resin 6. When the mainboard is turned power on, the power is supplied through the terminal part 100 and current is supplied through conductive patterns included in the electronic circuit 8. Thus, the electronic device 10 such as a LED can perform various functions in order to embody functions of automobiles. When the electronic device 10 is used for automobile electronic system, it can embody functions of light emitting and touch sensing (such as a capacitive and constant voltage touch sensor.)

### <The combining process between the film 2 and the second plastic resin 6>

The film 2 and the second plastic resin 6 integrated with the electronic circuit 8 and the electronic device 10, each of which is obtained from the processes above, are processed by an insert injection molding, and the final IME structure is completed.

The film 2 and the second plastic resin 6 have already been formed according to the shape of the product. In order to form the first plastic resin 5 described in FIG. 1, a mold including a cavity is prepared. A shape of the cavity is same as that of the final product. Then, the film 2 is mounted on a top portion of the cavity, and the second plastic resin 6 integrated with the electronic circuit 8 and the electronic device 10 is mounted on a bottom portion of the cavity. After mounting, an insert injection process is performed. A plastic resin is injected into and fills the cavity, and the plastic resin filled in the cavity is molded under a designated temperature and pressure. By the insert injection process, the first plastic resin 4 is formed, and at the same time, the IME structure 1 is completed, which comprises the film 2, the first plastic resin 4 disposed under the film 2, and the second plastic resin 6 disposed under the first plastic resin 4.

Materials of the first plastic resin 4 is not limited as with that of the second plastic resin 6; however, in case the electronic device 10 is a touch sensor, it is desirable that the materials of the first plastic resin 4 should have elasticity in order to transmit pressure fingers apply to the film 2.

While embodiments of the present invention have been described, the present invention is not limited to what has been particularly shown. Many more modifications than mentioned above are possible. It would be apparent that the scope of the present invention includes scopes of appended claims, modifications, and variations.

## Claims

1. An in-mold electronic structure comprising:
a film with a design;
a first plastic resin disposed under the film, and
a second plastic resin disposed under the first plastic resin,
wherein an electronic circuit is formed on a top side or both sides of the second plastic resin,
wherein an electronic device is mounted on the top side or the both sides of the second plastic resin,
wherein the film, the first plastic resin, and the second resin with the electronic circuit and the electronic device, are integrated.

2. The in-mold electronic structure of claim 1,
wherein an overall shape of the first plastic resin is similar to that of the film,
wherein a top side of the first plastic resin is combined with a bottom side of the film,
wherein the first plastic resin encapsules entireties of the top side and a lateral side of the second plastic resin.

3. The in-mold electronic structure of claim 2,
wherein a height of the second plastic resin is shorter than that of the first plastic resin,
wherein a width of the second plastic resin is shorter than that of the first plastic resin,
wherein a bottom side of the second plastic resin is exposed to outside.

4. The in-mold electronic structure of claim 3,
wherein a bottom side of the first plastic resin comprises:
an exposed part extended from an outermost edge of the in-mold electronic structure to the lateral side of the second plastic resin, and
an unexposed part directly facing the lateral side and the top side of the second plastic resin and combining with the second plastic resin.

5. The in-mold electronic structure of claim 3,
wherein the electronic circuit formed on the top side of the second plastic resin is electrically connected to an external terminal under the bottom side of the second plastic resin through one of structures:
a terminal connected the electronic circuit at the top side of the second plastic resin, extended from the top side to the bottom side of the second plastic resin through a penetrating hole formed in the second plastic resin, and exposed downward, or
a portion of the electronic circuit extended from the top side to the bottom side of the second plastic resin through the penetrating hole and exposed downward.

6. A method of an in-mold electronic structure comprising a film with a design, a first plastic resin disposed under the film, and a second plastic resin disposed under the first plastic resin, manufacturing the film comprises:
manufacturing a material layer with elastic plastic resin;
forming a design on the material layer using one of methods:
printing using one of silk screen, pad printing, ink jet printing, offset printing, or digital printing;
deposition, or
UV molding,
manufacturing a three dimensional shape by performing a forming process on the material layer with the design, the forming process one of heat forming, vacuum forming, or high pressure forming, and
cutting the material layer in the three dimensional shape to fit on a size of a product and completing the film.

7. A method of an in-mold electronic structure comprising a film with a design, a first plastic resin disposed under the film, and a second plastic resin disposed under the first plastic resin, manufacturing the second plastic resin comprises:
injection molding the second plastic resin according to a shape of a product, the injection molding comprising forming a penetrating hole in the second plastic resin;
forming an electronic circuit, by a plating process, on a top side, or both sides including the top side and a bottom side of the second plastic resin that is injection molded;
forming a protection layer on the electronic circuit formed on the bottom side of the second plastic resin when the electronic circuit is formed on the top and the bottom side of the second plastic resin, and
mounting an electronic device on the top side, or the top and bottom side of the second plastic resin with the electronic circuit by soldering, in order to minimize heat damage to the top side, or the top and the bottom side of the second plastic resin with the electronic circuit, the soldering comprising:
low temperature soldering using a low thermosetting soldering paste, or
local area heating soldering that is heating only a local area where a soldering paste is applied.

8. The method of claim 7, wherein the forming the electronic circuit on the second plastic resin by the plating process comprises:
performing a pre-treatment of the top side of the second plastic resin with alkaline solution or acidic solution for the plating process;
forming a fine concave and convex part on an area of the second plastic resin that the electronic circuit will be formed on, using laser, and
performing the plating process that conductive metal is filled in the concave part in order to embody the electronic circuit.

9. A method of an in-mold electronic structure comprising a film with a design, a first plastic resin disposed under the film, and a second plastic resin disposed under the first plastic resin, the method comprises:
providing the film and the second plastic resin, each formed according to a shape of a product, and
mounting the film on a top portion of a cavity of a mold and the second plastic resin on a bottom portion of the cavity, a shape of the cavity same as that of the product, and
forming the first plastic resin and completing the in-mold electronic structure comprising the film, the first plastic resin, and the second plastic resin by injecting a material of the first plastic resin into the cavity, filling the cavity with the material, and molding the structure under a designated temperature and pressure.

10. The method of claim 9, wherein the providing the second plastic resin comprises:
injection molding the second plastic resin according to a shape of a product, the injection molding comprising forming a penetrating hole in the second plastic resin;
forming an electronic circuit on a top side, or the top and a bottom side of the second plastic resin that is injection molded by a plating process;
forming a protection layer on the electronic circuit formed on the bottom side of the second plastic resin when the electronic circuit is formed on the top and the bottom side of the second plastic resin, and
mounting an electronic device on the top side, or the top and bottom side of the second plastic resin with the electronic circuit by one of low temperature soldering or local area heating soldering.

## Amended claims

### Amended claims in accordance with Rule 137(2) EPC.

1. A method of an in-mold electronic structure comprising a film (2) with a design, a first plastic resin (4) disposed under the film (2), and a second plastic resin (6) disposed under the first plastic resin (4), the method comprises:
providing the film (2) and the second plastic resin (6), each formed according to a shape of a product, and
mounting the film (2) on a top portion of a cavity of a mold and the second plastic resin (6) on a bottom portion of the cavity, a shape of the cavity same as that of the product, and
forming the first plastic resin (4) and completing the in-mold electronic structure comprising the film (2), the first plastic resin (4), and the second plastic resin (6) by injecting a material of the first plastic resin (4) into the cavity, filling the cavity with the material, and molding the structure under a designated temperature and pressure.

2. The method of claim 1, wherein the providing the second plastic resin (6) comprises:
injection molding the second plastic resin (6) according to a shape of a product, the injection molding comprising forming a penetrating hole (6') in the second plastic resin (4,6);
forming an electronic circuit (8) on a top side (6a), or the top and a bottom side (6b) of the second plastic resin (6) that is injection molded by a plating process;
mounting an electronic device (10) on the top side (6a), or the top and bottom side (6b) of the second plastic resin (6) with the electronic circuit (8) by one of low temperature soldering or local area heating soldering.

3. The method of claim 2, further comprising forming a protection layer on the electronic circuit (8) formed on the bottom side (6b) of the second plastic resin (6) when the electronic circuit (8) is formed on the top and the bottom side (6b) of the second plastic resin (6).
